# EUROPEAN PATENT APPLICATION

(11) **EP 4 840 905 A1**
(43) Date of publication of application: **18.11.2026**
(21) Application number: 25768692.3
(22) Date of filing: 04.03.2025
(51) Int. Cl.: C08L 63/00, C08G 59/62, C08K 3/013, C08K 3/36, C08J 5/18, H05K 1/03

(54) **CURABLE RESIN COMPOSITION, AND INSULATING FILM AND PRINTED CIRCUIT BOARD COMPRISING SAME**

(30) Priority: 04.03.2024 KR 20240030473
(71) Applicant: LG Chem, Ltd., Seoul 07336 (KR)
(72) Inventor: HWANG, Seongmin, Daejeon 34122 (KR); KIM, Tae Soon, Daejeon 34122 (KR); PARK, Daseul, Daejeon 34122 (KR); YOON, Youngsik, Daejeon 34122 (KR); LEE, Jonghwa, Daejeon 34122 (KR); CHOI, Byung Ju, Daejeon 34122 (KR)
(74) Representative: Hoffmann Eitle
(86) International application number: PCT/KR2025/099528
(87) International publication number: WO 2025/188137

(57) **Abstract**

The present disclosure provides a curable resin composition containing an epoxy resin, a phenol-based curing agent and an inorganic filler, wherein the phenol-based curing agent contains a mixture of a naphthol aralkyl backbone-containing phenol resin and a triazine backbone-containing phenol resin, and has an amine group content of 15 wt% or more based on the total triazine backbone-containing phenol resin. Since the curable resin composition has a low coefficient of thermal expansion while maintaining high peel strength, cracking of an insulating film can be prevented in a reliability test.

## Description

### [Technical Field]

The present disclosure relates to a curable resin composition, and an insulating film and a printed circuit board including the same.

This application claims the priority of Korean Patent Application No. 10-2024-0030473, filed on March 4, 2024 in the Korean Intellectual Property Office, and Korean Patent Application No. 10-2025-0027402, filed on March 4, 2025 in the Korean Intellectual Property Office, the contents of which in their entirety are herein incorporated by reference.

### [Background Art]

A printed circuit board (PCB) refers to a board as a support for electronic components, on which the electronic components are fixed on the surface of the printed wiring board and an electronic circuit is formed by connecting the components with copper wirings.

In general, the printed circuit board is formed as multiple layers by insulating the copper wirings from each other. In order to improve the reliability of the printed circuit board, the adhesion between an insulation layer and a copper layer is improved by including a component with high binding ability to Cu, increasing the surface layer of the interface by forming roughness on the surface of the insulation layer, etc.

As a method for preparing a multilayer printed circuit board, a method of stacking prepreg sheets on an inner layer circuit board with a copper foil circuit formed and then connecting layers with through-holes is known. However, this method is problematic in that it requires a large-scale facility, spends a lot of cost and time, and micropattern formation is difficult.

In order to solve this problem, a method of preparing a multilayer printed circuit board using a build-up method has been proposed recently. The build-up method is a technology of stacking organic insulation layers (or insulating films) alternately on a conductor layer of a circuit board.

But, due to the large difference in the coefficients of thermal expansion of the insulation layer and the copper wiring constituting the printed circuit board, cracking may occur in the insulation layer and/or the copper wiring in reliability test such as thermal cycles. Therefore, researches are being conducted to reduce the coefficient of thermal expansion of a resin composition constituting the insulation layer.

Recently, a method of adding an inorganic filler to reduce the coefficient of thermal expansion of a resin composition has been proposed. However, the increase in the addition amount of the inorganic filler makes the control of the viscosity of the resin composition difficult, and causes decreased peel strength of a conductor layer, etc. due to the exposure of the inorganic filler after roughening treatment.

Accordingly, further researches on the resin composition are necessary.

### [Disclosure]

### [Technical Problem]

The present disclosure relates to a curable resin composition, and an insulating film and a printed circuit board including the same.

### [Technical Solution]

The inventors of the present disclosure have found that, when two phenol resins having different backbones are introduced to a curable resin composition as phenol-based curing agents, the composition exhibits a low coefficient of thermal expansion and improved peel strength due to the rigid structure, when it is used for an insulating film.

Accordingly, the present disclosure provides the following embodiments.

An embodiment of the present disclosure provides a curable resin composition containing an epoxy resin, a phenol-based curing agent and an inorganic filler, wherein the phenol-based curing agent contains a mixture of a naphthol aralkyl backbone-containing phenol resin and a triazine backbone-containing phenol resin, and has an amine group content of 15 wt% or more based on the total triazine backbone-containing phenol resin.

Another embodiment of the present disclosure provides an insulating film containing the curable resin composition or a curing product thereof.

Another embodiment of the present disclosure provides a printed circuit board including the insulating film.

### [Advantageous Effects]

A curable resin composition according to the present disclosure can prevent cracking of an insulating film in a reliability test because it has a low coefficient of thermal expansion.

The curable resin composition according to the present disclosure can provide superior adhesion to a copper film due to its high peel strength in insulating film applications.

In particular, the curable resin composition according to the present disclosure can prevent the decline in peel strength under the condition where an inorganic filler is used at a high content.

### [Best Mode]

Hereinafter, the present disclosure will be described in more detail.

Throughout the present specification, when a certain member is described to be located "on" another member, this includes not only the case where a certain member is in contact with another member but also the case where another member exists between the two members.

Throughout the present specification, when a portion is referred to as "comprising" or "including" any element, it means that the portion may include other elements further, without excluding other elements, unless specifically stated otherwise.

In the present specification, a "polymer" refers to a compound consisting of repeating units (basic units). The polymer may be represented as a macromolecule(polymer) or a compound consisting of a macromolecule, and the polymer may have one or more repeating unit.

### <Curable resin composition>

Hereinafter, a curable resin composition according to an embodiment of the present disclosure will be described.

A curable resin composition according to an embodiment of the present disclosure contains a phenol-based curing agent. The phenol-based curing agent contains a mixture of a naphthol aralkyl backbone-containing phenol resin and a triazine backbone-containing phenol resin, and has an amine group content of 15 wt% or more based on the total triazine backbone-containing phenol resin.

By using the phenol-based curing agent containing two different phenol resins, wherein the amine group content of the triazine backbone-containing phenol resin satisfies the condition described above, high peel strength may be achieved even under the condition of a low coefficient of thermal expansion.

According to an embodiment of the present disclosure, the amine group content may be 15 wt% or higher, 16 wt% or higher, 17 wt% or higher, or 18 wt% or higher, and 30 wt% or lower, 29 wt% or lower, 28 wt% or lower, 27 wt% or lower, or 26 wt% or lower, based on the total triazine backbone-containing phenol resin.

According to an embodiment of the present disclosure, the epoxy resin may include a phenol novolac-type epoxy resin.

In the present disclosure, the phenol novolac-type epoxy resin may be, for example, YDPN-638 or YDPN-639 (Shin Nittetsu Chemical), although not being limited thereto.

According to an embodiment of the present disclosure, the content of the phenol novolac-type epoxy resin may be 40 wt% or higher, 45 wt% or higher, 50 wt% or higher, 55 wt% or higher, or 60 wt% or higher, and 90 wt% or lower, 85 wt% or lower, 80 wt% or lower, 75 wt% or lower, 70 wt% or lower, or 65 wt% or lower, based on the 100 wt% of total epoxy resin.

Specifically, when the content of the phenol novolac-type epoxy resin satisfies the above condition, a microcircuit may be formed easily since surface roughness of 300 nm or larger and 400 nm or smaller can be achieved more easily.

According to an embodiment of the present disclosure, the compositional ratio of the naphthol aralkyl backbone-containing phenol resin and the triazine backbone-containing phenol resin may be 1 : 10 to 10 : 1 based on parts by weight.

According to an embodiment of the present disclosure, the compositional ratio of the naphthol aralkyl backbone-containing phenol resin and the triazine backbone-containing phenol resin may be 1 : 8 to 8 : 1, 1 : 6 to 6 : 1, or 1 : 4 to 4 : 1, based on weight.

When the above-described compositional ratio of the two different phenol resins is satisfied, high peel strength can be achieved additionally under a condition of a low coefficient of thermal expansion.

According to an embodiment of the present disclosure, the naphthol aralkyl backbone-containing phenol resin may be represented by Structural Formula 1.

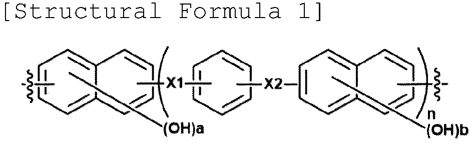

In Structural Formula 1, 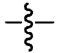 indicates connection to another structure,
each of X1 and X2, which are identical or different, is independently a divalent organic group,
each of a and b, which are identical or different, is independently an integer from 1 to 6, and
n is an integer from 1 to 20.

According to an embodiment of the present disclosure, each of X1 and X2, which are identical or different, may independently be a substituted or unsubstituted alkylene group; a substituted or unsubstituted arylene group; or a substituted or unsubstituted divalent amine group.

According to an embodiment of the present disclosure, each of X1 and X2, which are identical or different, may independently be a substituted or unsubstituted C₁-C₃₀ alkylene group; a substituted or unsubstituted C₆-C₃₀ arylene group; or a substituted or unsubstituted divalent amine group.

According to an embodiment of the present disclosure, each of a and b, which are identical or different, may independently be an integer from 1 to 6, preferably an integer from 1 to 4, more preferably 1 or 2, most preferably 1.

According to an embodiment of the present disclosure, when n is an integer which is 2 or greater, the repeating units in the parentheses may be identical or different from each other.

According to an embodiment of the present disclosure, the end group of the naphthol aralkyl backbone-containing phenol resin may be hydrogen; a hydroxyl group; an ester group; a cyanate ester group; a substituted or unsubstituted alkyl group; or a substituted or unsubstituted aryl group, although not being limited thereto.

In the present disclosure, the ester group may mean an active ester group. The active ester group is an ester functional group that is susceptible to nucleophilic attack and may be one in which the acyl or alkoxy components of a normal ester are modified.

According to an embodiment of the present disclosure, the end group of the naphthol aralkyl backbone-containing phenol resin may be hydrogen; a substituted or unsubstituted C₁-C₃₀ alkyl group; or a substituted or unsubstituted C₆-C₃₀ aryl group, although not being limited thereto.

According to an embodiment of the present disclosure, the naphthol aralkyl backbone-containing phenol resin may be SN-395, SN-485, SN-395 (Shin Nittetsu Chemical), etc., although not being limited thereto.

According to an embodiment of the present disclosure, the triazine backbone-containing phenol resin may be represented by Structural Formula 2.

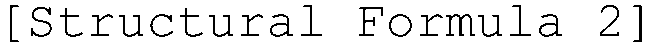

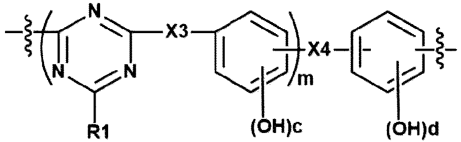

In Structural Formula 2, 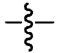 indicates connection to another structure,
each of X3 and X4, which are identical or different, is independently a divalent organic group,
R1 is hydrogen; a substituted or unsubstituted alkyl group; a substituted or unsubstituted aryl group; or a substituted or unsubstituted amine group,
each of c and d, which are identical or different, is independently an integer from 1 to 4, and
m is an integer from 1 to 20.

According to an embodiment of the present disclosure, R1 may be a substituted or unsubstituted C₁-C₃₀ alkyl group; a substituted or unsubstituted C₆-C₃₀ aryl group; or a substituted or unsubstituted amine group.

According to an embodiment of the present disclosure, each of X3 and X4, which are identical or different, may independently be a substituted or unsubstituted alkylene group; a substituted or unsubstituted arylene group; or a substituted or unsubstituted divalent amine group.

According to an embodiment of the present disclosure, each of X3 and X4, which are identical or different, may independently be a substituted or unsubstituted C₁-C₃₀ alkylene group; a substituted or unsubstituted C₆-C₃₀ arylene group; or a substituted or unsubstituted divalent amine group.

According to an embodiment of the present disclosure, each of c and d, which are identical or different, may independently be an integer from 1 to 4, preferably an integer from 1 to 3, more preferably 1 or 2, most preferably 1.

According to an embodiment of the present disclosure, the end group of the triazine backbone-containing phenol resin may be hydrogen; a substituted or unsubstituted alkyl group; or a substituted or unsubstituted aryl group. Preferably, it may be hydrogen or a methyl group.

According to an embodiment of the present disclosure, the end group of the triazine backbone-containing phenol resin may be hydrogen; a substituted or unsubstituted C₁-C₃₀ alkyl group; or a substituted or unsubstituted C₆-C₃₀ aryl group.

According to an embodiment of the present disclosure, the triazine backbone-containing phenol resin may be LA-1356, LA-7052, LA-7054, LA-3018-80P, etc., although not being limited thereto.

According to an embodiment of the present disclosure, the epoxy resin may be any one known in the art without limitation, but it may be derived from an epoxy compound having two or more identical or different epoxy groups.

According to an embodiment of the present disclosure, the epoxy resin may include, in addition to the phenol novolac-type epoxy resin, any one known in the art without limitation, for example, a bisphenol-type epoxy resin; a novolac-type epoxy resin; a bixylenol-type epoxy resin; a biphenyl-type epoxy resin, etc., which may be used either alone or in combination with each other.

In an embodiment of the present disclosure, the epoxy resin may be YX4000H (Mitsubishi Chemical), YDF-170, YDF-172, YD-113, YD-114, YD-114E, YD-114F, YD-115, YD-115G, YD-115CA, KT-7804, KD-1818, YD-127, YD-128, YD-128S, YD-134, YD-136 (Kukdo Chemical), EXA-4850-150, EXA-4850-1000 (DIC), etc., although not being limited thereto.

According to an embodiment of the present disclosure, the content of the epoxy resin may be 10 parts by weight or more based on 100 parts by weight of the total curable resin composition.

According to an embodiment of the present disclosure, the content of the epoxy resin may be 11 parts by weight or more, 12 parts by weight or more, or 13 parts by weight or more, and 30 parts by weight or less, 29 parts by weight or less, or 28 parts by weight or less, based on 100 parts by weight of the total curable resin composition.

When the content of the epoxy resin is within the above-described ranges, improved moldability and processability, or properties required to achieve appropriate surface roughness during the desmear process may be ensured.

In the present disclosure, the range of surface roughness may vary depending on curing temperature, desmear condition, etc.

According to an embodiment of the present disclosure, the content of the phenol-based curing agent may be 10 parts by weight or more based on 100 parts by weight of the total curable resin composition.

According to an embodiment of the present disclosure, the content of the phenol-based curing agent may be 11 parts by weight or more, 12 parts by weight or more, or 13 parts by weight or more, and 30 parts by weight or less, 29 parts by weight or less, or 28 parts by weight or less, based on 100 parts by weight of the total curable resin composition.

When the content of the phenol-based curing agent is within the above-described ranges, improved heat resistance and dielectric property, or properties required to achieve appropriate surface roughness during the desmear process may be ensured.

Without departing from the context of the present disclosure, curing agents other than the phenol-based curing agent may be further included.

According to an embodiment of the present disclosure, the content of the inorganic filler may be 50 parts by weight or more based on 100 parts by weight of the total curable resin composition.

According to an embodiment of the present disclosure, the content of the inorganic filler may be 51 parts by weight or more, 53 parts by weight or more, or 55 parts by weight or more, and 100 parts by weight or less, 98 parts by weight or less, or 95 parts by weight or less, based on 100 parts by weight of the total curable resin composition.

In the present disclosure, the inorganic filler is used to control desired properties, such as reduced hygroscopicity, high storage modulus, low coefficient of thermal expansion (CTE), viscosity and enhanced curability of the curable resin composition.

According to an embodiment of the present disclosure, the average particle diameter of the inorganic filler may be 0.01 µm or larger and 5 µm or smaller.

According to an embodiment of the present disclosure, the inorganic filler may be surface-treated with a surface treatment agent such as a coupling agent, etc.

According to an embodiment of the present disclosure, the inorganic filler may be silica, silicate, barium sulfate, alumina, etc., although not being limited thereto.

In the present disclosure, the silica may be, for example, spherical silica, molten silica, hollow silica, crystalline silica, amorphous silica, etc., although not being limited thereto, and SOC1, SOC2 (Admatechs), etc. are commercially available.

According to an embodiment of the present disclosure, the curable resin composition may further contain at least one of a thermoplastic resin; a curing accelerator; and a solvent.

According to an embodiment of the present disclosure, the content of the thermoplastic resin may be 0.1 part by weight or more based on 100 parts by weight of the total curable resin composition.

According to an embodiment of the present disclosure, the content of the thermoplastic resin may be 0.5 part by weight or more, 0.7 part by weight or more, or 1.0 part by weight or more, and 5 parts by weight or less, 4.5 parts by weight or less, or 4 parts by weight or less, based on 100 parts by weight of the total curable resin composition.

According to an embodiment of the present disclosure, the thermoplastic resin is not particularly limited as long as it is one widely known in the art. For example, a polyvinyl acetal resin (KS-1), etc. may be used.

According to an embodiment of the present disclosure, the content of the curing accelerator may be 0.05 part by weight or more based on 100 parts by weight of the total curable resin composition.

According to an embodiment of the present disclosure, the content of the curing accelerator may be 0.08 part by weight or more, 0.09 part by weight or more, or 0.1 part by weight or more, and 1 part by weight or less, 0.9 part by weight or less, or 0.8 part by weight or less, based on 100 parts by weight of the total curable resin composition.

According to an embodiment of the present disclosure, the curing accelerator is not particularly limited as long as it is one widely known in the art.

In the present disclosure, the curing accelerator is not particularly limited as long as it is one widely known in the art as a material for accelerating the curing of the thermosetting resin composition together with the curing agent. For example, a pyridine-based curing accelerator (DMAP), an imidazole-based curing accelerator (e.g., 2PHZ-PW), an amine-based curing accelerator (e.g., dicyandiamide), an organic phosphine compound, an inorganic metal-based curing accelerator (e.g., cobalt(II) acetylacetonate (TCI)), etc. may be used either alone or in combination.

According to an exemplary embodiment of the present disclosure, the solvent may be any compound known to enable the formation of a curable resin composition in the art to which the present disclosure belongs without special limitation. As nonlimiting examples, the solvent may be one or more compound selected from a group consisting of esters, ethers, ketones, aromatic hydrocarbons and sulfoxides.

The ester-based solvent may be ethyl acetate, n-butyl acetate, isobutyl acetate, amyl formate, isoamyl acetate, butyl propionate, isopropyl butyrate, ethyl butyrate, butyl butyrate, methyl lactate, ethyl lactate, γ-butyrolactone, ε-caprolactone, δ-valerolactone, alkyl oxyacetate (e.g., methyl oxyacetate, ethyl oxyacetate, butyl oxyacetate (e.g., methyl methoxyacetate, ethyl methoxyacetate, butyl methoxyacetate, methyl ethoxyacetate, ethyl ethoxyacetate, etc.)), 3-oxypropionic acid alkyl ester (e.g.,methyl 3-oxypropionate, ethyl 3-oxypropionate, etc. (e.g., methyl 3-methoxypropionate, ethyl 3-methoxypropionate, methyl 3-ethoxypropionate, ethyl 3-ethoxypropionate, etc.)), 2-oxypropionic acid alkyl ester (e.g. methyl 2-oxypropionate, ethyl 2-oxypropionate, propyl 2-oxypropionate and the like (e.g., methyl 2-methoxypropionate, ethyl 2-methoxypropionate, propyl 2-methoxypropionate, methyl 2-ethoxypropionate, ethyl 2-ethoxypropionate)), methyl 2-oxy-2-methylpropionate and ethyl 2-oxy-2-methylpropionate (e.g., methyl 2-methoxy-2-methylpropionate, ethyl 2-ethoxy-2-methylpropionate, etc.), methyl pyruvate, ethyl pyruvate, propyl pyruvate, methyl acetoacetate, ethyl acetoacetate, methyl 2-oxobutyrate, ethyl 2-oxobutyrate, etc.

The ether-based solvent may be diethylene glycol dimethyl ether, tetrahydrofuran, ethylene glycol monomethyl ether, ethylene glycol monoethyl ether, methyl cellosolve acetate, ethyl cellosolve acetate, diethylene glycol monomethyl ether, diethylene glycol monoethyl ether, diethylene glycol monobutyl ether, propylene glycol monomethyl ether, propylene glycol monomethyl ether acetate, propylene glycol monoethyl ether acetate, propylene glycol monopropyl ether acetate, etc.

The ketone-based solvent may be methyl ethyl ketone (MEK), cyclohexanone, cyclopentanone, 2-heptanone, 3-heptanone, N-methyl-2-pyrrolidone, etc.

The aromatic hydrocarbon-based solvent may be toluene, xylene, anisole, limonene, etc.

The sulfoxide-based solvent may be dimethyl sulfoxide, etc.

According to an embodiment of the present disclosure, the curable resin composition may further contain an additive, and the additive may be selected from a group consisting of a leveling agent, a wetting agent, an antistatic agent and an antioxidant.

In the present disclosure, the leveling agent is not particularly limited as long as it is one known in the art as a material for preventing defects such as craters on the surface by controlling the flowability of the curable resin composition. As occasion arises, the leveling agent may be used either alone or in combination.

In the present disclosure, the wetting agent is not particularly limited as long as it is one known in the art as a material for helping the aggregation of the inorganic filler by accelerating wetting. As occasion arises, the wetting agent may be used either alone or in combination.

In the present disclosure, the antistatic agent is not particularly limited as long as it is one known in the art as a material for providing antistatic effect. As occasion arises, the antistatic agent may be used either alone or in combination.

In the present disclosure, the antioxidant is not particularly limited as long as it is one known in the art as a material for improving thermal stability. As occasion arises, the antioxidant may be used either alone or in combination.

### <Insulating film>

Another embodiment of the present disclosure provides an insulating film containing the curable resin composition or a curing product thereof.

In the present disclosure, the curing product may be obtained by thermal curing and/or photocuring.

In the present disclosure, the thermal curing may be performed under the condition known in the art using a heating device. For example, it may be performed by curing and drying for a predetermined time under the condition of 100 °C or higher.

In the present disclosure, the photocuring may be performed under the condition known in the art using a UV-irradiating device. For example, it may be performed with UV having a wavelength of 365 nm (LED 3000 mJ/cm² to 5000 mJ/cm²).

In an embodiment of the present disclosure, the insulating film may have a coefficient of thermal expansion of 25 ppm/°C or lower.

In the present disclosure, the coefficient of thermal expansion (CTE) may be measured and evaluated by obtaining a curing product in sheet form by thermally curing a resin composition film at 190 °C for 1 hour and 30 minutes and, cutting the curing product into a test specimen with a width of about 4 mm and a length of about 24 mm, and conducting thermomechanical analysis twice continuously by the tensile weight method using a thermomechanical analyzer (TMA) under the condition of heating rate of 5 °C/min. During the second measurement, the mean coefficient of linear thermal expansion (ppm) is calculated from 25 °C to 150 °C (α₁, below T_{g}).

In an embodiment of the present disclosure, the insulating film may have a peel strength measured according to ASTM D6862 of 0.4 kgf/cm or higher.

Since the insulating film is the curable resin composition described above or a curing product thereof, the foregoing description of the curable resin composition also applies.

### <Printed circuit board>

Hereinafter, a printed circuit board according to an embodiment of the present disclosure will be described.

Since the printed circuit board includes an insulating film which is the curable resin composition described above or a curing product thereof, the foregoing description of the curable resin composition also applies.

### [Mode for Invention]

Hereinafter, the present disclosure will be described in detail through examples. However, the examples of the present disclosure may be varied into various other forms, and the scope of the present disclosure should not be construed as being limited to the examples described below. The examples of the present disclosure are provided to more completely explain the present disclosure to those having ordinary knowledge in the art.

### Examples. Preparation of curable resin composition and insulating film

### <Example 1>

20 parts by weight of a bisphenol-type epoxy resin (YD-128, Kukdo Chemical), 30 parts by weight of a phenol novolac-type epoxy resin (YDPN-639, Kukdo Chemical) and 60 parts by weight of a bixylenol-type epoxy resin (YX-4000H) as epoxy resins, 70 parts by weight of a triazine backbone-containing phenol resin (Phenolite LA-1356, DIC) and 40 parts by weight of a naphthol aralkyl backbone-containing phenol resin (SN-485) as phenol-based curing agents, 450 parts by weight of a silica slurry (SOC2) with an average particle diameter (D₅₀) of 0.1 µm as an inorganic filler, and 10 parts by weight of a polyvinyl acetal resin (KS-1) as a thermoplastic resin were mixed in an MEK solvent to a total solid content of 70%. After stirring at 250 rpm for 3 hours with a mechanical stirrer, a curable resin composition was prepared by mixing with a curing accelerator (DMAP, 4-dimethylaminopyridine) using a paste mixer.

Then, after coating the curable resin composition on a 38µm PET film using an applicator, an insulating film with a thickness of 30 µm was prepared by drying at 100 °C for 8 minutes.

### <Examples 2 to 5 and Comparative Examples 1 to 5>

Curable resin compositions were prepared in the same manner as in Example 1, except that compositions and contents were changed as described in Table 1.

**[Table 1]**

| | | Ex. 1 | Ex. 2 | Ex. 3 | Ex. 4 | Ex. 5 | Comp. Ex. 1 | Comp. Ex. 2 | Comp. Ex. 3 | Comp. Ex. 4 | Comp. Ex. 5 |
|---|---|---|---|---|---|---|---|---|---|---|---|
| Epoxy resin (A) | YD-128 | 20 | 20 | 20 | 20 | 20 | 20 | 20 | 20 | 20 | 20 |
| | YX-4000H | 30 | 30 | 30 | 30 | 30 | 30 | 30 | 30 | 30 | 30 |
| | YDPN-639 | 60 | 60 | 60 | 60 | 60 | 60 | 60 | 60 | 60 | 60 |
| Phenol curing agent (B) | LA-1356 (19 wt% amine) | 70 | 60 | 50 | 50 | 40 | - | 110 | 69 | - | - |
| | SN-485 | 40 | 50 | 50 | 60 | 70 | 80 | - | - | 40 | 40 |
| | *GPH-63 | - | - | - | - | - | - | - | 41 | - | - |
| | LA-7052 (8 wt% amine) | - | - | - | - | - | - | - | - | 70 | - |
| | LA-7054 (12 wt% amine) | - | - | - | - | - | - | - | - | | 70 |
| Inorganic filler (C) | SOC2 | 450 | 450 | 450 | 450 | 450 | 450 | 450 | 450 | 450 | 450 |
| Thermoplastic resin (D) | KS-1 | 10 | 10 | 10 | 10 | 10 | 10 | 10 | 10 | 10 | 10 |
| Curing accelerator | DMAP | 2.5 | 2.5 | 2.5 | 2.5 | 2.5 | 2.5 | 2.5 | 2.5 | 2.5 | 2.5 |

| | | | | | | | | | | | |
|---|---|---|---|---|---|---|---|---|---|---|---|
| * In Table 1, GPH-63 is a biphenyl aralkyl phenol-based resin, which is a phenol curing agent not containing the naphthol aralkyl backbone or triazine backbone. | | | | | | | | | | | |

### <Test Examples>

### 1) Test Example 1: Measurement of coefficient of thermal expansion (CTE)

The insulating films prepared in Examples 1 to 5 and Comparative Examples 1 to 5 were cut into samples with a width of 4.8 mm, a length of 16 mm and a thickness of 30 µm and thermally cured at 190 °C for 90 minutes. Then, the coefficient of thermal expansion was measured in the range of 25 °C to 120 °C using a TMA. The measurement result is shown in Table 2.

### 2) Test Example 2: Evaluation of high-temperature reliability

After conducting desmear treatment for the insulating films prepared in Examples 1 to 5 and Comparative Examples 1 to 5, surface roughness and adhesivity to a copper film were measured. The measurement result is shown in Table 2.

Desmear treatment condition: Sweller 60 °C * 10 min, PerMn 80 °C * 25 min, Reduction 50 °C * 5 min.

Surface roughness measurement: lens: i20x, F.O.V: 0.55x, WSI.

Measurement of adhesivity to copper film(peel strength): 10 mm x 100 mm sample, peel test (90° peel angle, 50 mm/min peel speed).

**[Table 2]**

| | Ex. 1 | Ex. 2 | Ex. 3 | Ex. 4 | Ex. 5 | Comp. Ex. 1 | Comp. Ex. 2 | Comp. Ex. 3 | Comp. Ex. 4 | Comp. Ex. 5 |
|---|---|---|---|---|---|---|---|---|---|---|
| Content of inorganic filler (%) | 63 | 63 | 63 | 63 | 63 | 63 | 63 | 63 | 63 | 63 |
| Coefficient of thermal expansion (ppm/°C) | 25 | 25 | 24 | 24 | 23 | Not measured | 27 | 29 | 28 | 27 |
| Surface roughness (nm) | 330 | 320 | 350 | 340 | 350 | 600 | 700 | 650 | 600 | 500 |
| Adhesivity to copper film (peel strength, kgf/cm) | 0.40 | 0.40 | 0.45 | 0.45 | 0.45 | Blister | 0.3 | 0.2 | 0.30 | 0.35 |

As shown in Table 2, under the same conditions with a high content of inorganic filler, the insulating films of Examples 1 to 5 exhibited a high peel strength of 0.40 kgf/cm or higher and a uniform surface roughness of 300 nm to 400 nm, while satisfying a coefficient of thermal expansion of 25 ppm/°C or lower. Accordingly, they exhibited physical properties suitable for microcircuit patterning compared to the insulating films of Comparative Examples 1 to 5.

In particular, the insulating film of Comparative Example 1, which was prepared from a curable resin composition not containing a triazine backbone-containing phenol resin, was not suitable for use as an insulating film due to blister formation. In addition, for the insulating films of Comparative Examples 2 and 3, which were prepared from a curable resin composition not containing the naphthol aralkyl backbone-containing phenol resin or containing a different phenol-based curing agent, it was difficult to ensure minimum warpage because the coefficient of thermal expansion exceeded 25 ppm/°C. In addition, they were not suitable for use as insulating films because of low yield, peel strength below 0.4 kgf/cm and short circuit during the reliability test. And, the insulating films of Comparative Examples 4 and 5, wherein the triazine backbone-containing phenol resin with an amine group content less than 15 wt% (LA-7052, LA-7054) was used, were not suitable for use as insulating films due to a coefficient of thermal expansion exceeding 25 ppm/°C and a peel strength lower than 0.4 kgf/cm. In addition, they were not suitable for microcircuit patterning due to the surface roughness not reaching 300 nm to 400 nm.

## Claims

1. A curable resin composition comprising an epoxy resin, a phenol-based curing agent and an inorganic filler, wherein
the phenol-based curing agent comprises a mixture of a naphthol aralkyl backbone-containing phenol resin and a triazine backbone-containing phenol resin, and
has an amine group content of 15 wt% or more based on the total triazine backbone-containing phenol resin.

2. The curable resin composition according to claim 1, wherein the epoxy resin comprises a phenol novolac-type epoxy resin.

3. The curable resin composition according to claim 1, wherein the compositional ratio of the naphthol aralkyl backbone-containing phenol resin and the triazine backbone-containing phenol resin is 1 : 10 to 10 : 1 based on parts by weight.

4. The curable resin composition according to claim 1, wherein the naphthol aralkyl backbone-containing phenol resin is represented by Structural Formula 1: 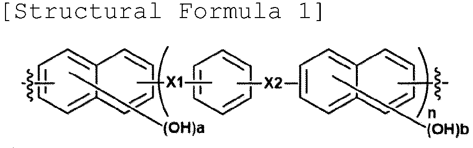 wherein Structural Formula 1, 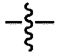 indicates connection to another structure,
each of X1 and X2, which are identical or different, is independently a divalent organic group,
each of a and b, which are identical or different, is independently an integer from 1 to 6, and
n is an integer from 1 to 20.

5. The curable resin composition according to claim 1, wherein the triazine backbone-containing phenol resin is represented by Structural Formula 2: 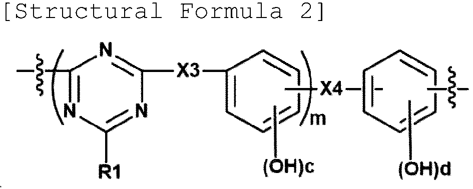 wherein Structural Formula 2, 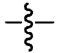 indicates connection to another structure,
each of X3 and X4, which are identical or different, is independently a divalent organic group,
R1 is hydrogen; a substituted or unsubstituted alkyl group;
a substituted or unsubstituted aryl group; or a substituted or unsubstituted amine group,
each of c and d, which are identical or different, is independently an integer from 1 to 4, and
m is an integer from 1 to 20.

6. The curable resin composition according to claim 1, wherein the content of the inorganic filler is 50 parts by weight or more based on 100 parts by weight of the total curable resin composition.

7. The curable resin composition according to claim 1, which further comprises at least one of a thermoplastic resin and a curing accelerator.

8. The curable resin composition according to claim 1, which further comprises an additive, wherein the additive is selected from a group consisting of a leveling agent, a wetting agent, an antistatic agent and an antioxidant.

9. An insulating film comprising the curable resin composition according to any of claims 1 to 8 or a curing product thereof.

10. The insulating film according to claim 9, which has a CTE (coefficient of thermal expansion) value of 25 ppm/°C or lower.

11. The insulating film according to claim 9, which has a peel strength of 0.4 kgf/cm or higher as measured by ASTM D6862.

12. A printed circuit board comprising the insulating film according to claim 9.
